# FASCICULE DE BREVET EUROPEEN

(11) **EP 3 140 901 B1**
(45) Date de publication et mention de la délivrance du brevet: **14.03.2018**
(21) Numéro de dépôt: 15724339.5
(22) Date de dépôt: 28.04.2015
(51) Int. Cl.: H02K 11/04

(54) **ENSEMBLE ÉLECTRONIQUE POUR MACHINE ÉLECTRIQUE TOURNANTE POUR VÉHICULE AUTOMOBILE**
ELEKTRONISCHE BAUGRUPPE FÜR EINE ELEKTRISCHE DREHMASCHINE FÜR EIN KRAFTFAHRZEUG
ELECTRONIC ASSEMBLY FOR AN ELECTRICAL ROTATING MACHINE FOR A MOTOR VEHICLE

(30) Priorité: 05.05.2014 FR 1454039
(43) Date de publication de la demande: 15.03.2017
(73) Titulaire: Valeo Equipements Electriques Moteur, 94046 Créteil Cedex (FR)
(72) Inventeur: EL BARAKA, Khadija, 77700 Serris (FR); JUGOVIC, Svetislav, 91200 Athis-Mons (FR); BOUDJEMAI, Farouk, 91460 Marcoussis (FR)
(74) Mandataire: Duprez, Richard
(86) Numéro de dépôt international: PCT/FR2015/051143
(87) Numéro de publication internationale: WO 2015/170035

(56) Documents cités:
- WO-A2-2010/037976
- FR-A1- 2 967 845

## Description

### DOMAINE TECHNIQUE DE L'INVENTION

La présente invention concerne un ensemble électronique pour machine électrique tournante pour véhicule automobile. La présente invention concerne également une machine électrique tournante comportant un tel ensemble électronique.

Elle trouve une application particulière mais non limitative dans le domaine des alterno-démarreurs de véhicule automobile.

### ARRIÈRE-PLAN TECHNOLOGIQUE DE L'INVENTION

Dans un véhicule automobile comportant un moteur thermique et une machine électrique tournante telle qu'un alterno-démarreur, un telle machine comporte de manière non limitative :
- un rotor comprenant un inducteur dans lequel est amené un courant d'excitation ; et
- un stator comprenant un bobinage polyphasé.

L'alterno-démarreur fonctionne en mode moteur ou en mode générateur. C'est une machine dite réversible.

En mode alternateur appelé également mode générateur, la machine permet de transformer un mouvement de rotation du rotor entraîné par le moteur thermique du véhicule, en un courant électrique induit dans les phases du stator. Dans ce cas, un pont redresseur relié aux phases du stator permet de redresser le courant induit sinusoïdal en un courant continu pour alimenter des consommateurs du véhicule ainsi qu'une batterie.

Au contraire, en mode moteur, la machine électrique fait office de moteur électrique permettant d'entraîner en rotation, via l'arbre du rotor, le moteur thermique du véhicule. Il permet de transformer l'énergie électrique en énergie mécanique. Dans ce cas un onduleur permet de transformer un courant continu provenant de la batterie en un courant alternatif pour alimenter les phases du stator pour faire tourner le rotor.

Des composants de contrôle sont utilisés pour déterminer le mode de fonctionnement de la machine électrique tournante (mode moteur ou mode générateur) via des signaux de contrôle.

Les composants de puissance (pont redresseur et onduleur) sont en général répartis en un module de puissance par bras de pont redresseur/onduleur. Chaque module de puissance est composé :
- d'une pièce de traces conductrices surmoulées de type IML (IML pour « Isolated Molded Leadframe » en anglais) contenu dans un boîtier plastique haut de gamme capable de supporter des températures élevées. Une pluralité d'interrupteurs électroniques, classiquement des MOSFET, sont soudés à haute température sur le circuit de traces conductrices, les interrupteurs électroniques d'un module étant destinés à réaliser un bras de pont redresseur/onduleur pour une phase de la machine électrique tournante ;
- d'un substrat de type céramique sur lequel sont collés des composants (dits « driver » en anglais) destinés à réaliser la commande des interrupteurs de puissance ;
- d'une plaque conductrice arrière, typiquement en aluminium (dite « backplate » en anglais), permettant de réaliser la masse du pont redresseur/onduleur ;
- d'un capot en plastique type PPS, PBT ou PA, permettant d'assurer l'étanchéité du module de puissance ;
- de broches, ou « pins » de connexion de signal intégrées au boîtier et qui assurent une connexion avec une pièce d'interconnexion permettant un transit de signaux de puissance entre le module de puissance et un module de contrôle.

Chaque module de puissance est testé unitairement puis monté sur un dissipateur de la machine électrique au moyen d'une pluralité de vis par module de puissance. Ensuite, pour chaque module de puissance on effectue, d'une part, des soudures électriques pour une connexion aux phases de la machine électrique et à un inter-connecteur de puissance pour une connexion à une borne, dite borne B+, de raccordement à la batterie du véhicule et, d'autre part, des soudures lasers pour une connexion de broches de signal à un module de contrôle. Puis on effectue une dépose de résine ou gel silicone afin de garantir une protection des soudures laser contre les agressions de l'environnement et d'assurer l'étanchéité du module. Et pour finir, la machine électrique est testée dans son ensemble.

Un inconvénient de cet état de la technique réside dans le fait que lors du test final de la machine électrique dans son ensemble, si un quelconque problème est détecté par exemple sur un module de puissance, l'ensemble de la machine électrique doit être mise au rebut car la suppression des soudures entraîne une détérioration de la machine électrique.

Dans ce contexte, la présente invention vise à résoudre l'inconvénient précédemment mentionné. Des ensembles électroniques pour machines électriques tournantes sont aussi connus des documents WO2010/037976 et FR2967845

### DESCRIPTION GENERALE DE L'INVENTION

A cette fin l'invention propose un ensemble électronique pour machine électrique tournante pour véhicule automobile, l'ensemble électronique comportant :
- une pièce-boîtier surmoulée en matériau plastique comprenant :
   - une pluralité de logements adaptés pour recevoir chacun un module de puissance;
- une pièce conductrice de puissance surmoulée dans la pièce-boîtier surmoulée
- des orifices de montage adaptés pour recevoir des moyens de montage pour monter chaque module de puissance sur la pièce-boîtier surmoulée ;
- caractérisé en ce que:
   - la pièce -boîtier surmoulé (100) comporte une pluralité de traces de phases et masse (103a,103b,102);
   - l'ensemble électronique (10) comporte en outre:
      - une pluralité de modules de puissance comprenant :
         - un support conducteur sur laquelle sont montés :
            - une pluralité d'interrupteurs électroniques de puissance ;
            - des composants de signal ;
            le support conducteur comprenant :
            - un connecteur de puissance adapté pour être connecté à la pièce conductrice de puissance de la pièce-boîtier surmoulée ;
            - au moins deux connecteurs de phase adaptés pour être connectés aux traces de phases de la pièce-boîtier surmoulée ;
         - une plaque de masse inférieure adaptée pour recevoir ladite pièce-boîtier surmoulée et pour être montée sur un dissipateur de la machine électrique tournante.

Ainsi, grâce à la pièce-boîtier surmoulée en matériau plastique de l'ensemble électronique, et grâce aux moyens mécaniques de montage (les orifices notamment) de la pièce-boîtier surmoulée associés à chaque module, lorsque la machine électrique ne fonctionne pas en raison par exemple d'un module de puissance, il suffit de démonter ce module de puissance de la pièce-boîtier surmoulée pour le mettre au rebut, de le remplacer par un nouveau module de puissance et de tester de nouveau l'ensemble électronique puis la machine électrique dans son ensemble. Il n'est plus nécessaire de mettre au rebut toute la machine électrique.

Selon des modes de réalisation non limitatifs, l'ensemble électronique, peut comporter en outre une ou plusieurs caractéristiques supplémentaires parmi les suivantes :
- Le matériau plastique de la pièce-boîtier surmoulée est du PPS ou PBT.
- La pièce conductrice de puissance de la pièce-boîtier surmoulée comporte une pluralité de languettes de connexion de puissance disposées parallèlement au plan de la pièce-boîtier surmoulée, une languette de connexion de puissance étant adaptée pour coopérer avec un module de puissance.
- Les traces de phase de la pièce-boîtier surmoulée comportent chacune une première languette de connexion de phase adaptée pour connecter un module de puissance, une première languette de connexion de phase étant positionnée parallèlement par rapport au plan de la pièce-boîtier surmoulée.
- Les traces de phase de la pièce-boîtier surmoulée comportent chacune une deuxième languette de connexion de phase adaptée pour connecter une phase du stator, une première languette étant positionnée verticalement par rapport au plan de la pièce-boîtier surmoulée.
- La pièce-boîtier surmoulée comporte des premiers et deuxièmes orifices de montage et la plaque de masse inférieure comporte des troisièmes et quatrièmes orifices de montage, les orifices de montage étant adaptés pour monter l'ensemble électronique sur un dissipateur de la machine électrique tournante.
- Le support conducteur d'un module de puissance est une carte à circuit imprimée (PCB).
- Les connecteurs de puissance et de phase d'un module de puissance comprennent des orifices de montage respectif adaptés pour être positionnés en vis-à-vis des orifices de montage de la pièce-boîtier surmoulée et pour recevoir les moyens de montage.
- Les connecteurs de puissance et de phase d'un module de puissance sont positionnés parallèlement au plan du support conducteur.

Il est également proposé une machine électrique tournante comportant :
- un rotor ;
- un stator couplé au rotor et comportant une pluralité de phases ;
- un ensemble électronique tel que décrit brièvement ci-dessus, la pièce-boîtier surmoulée en matériau plastique de l'ensemble électronique étant adaptée pour être connectée aux phases du stator ;
- un palier arrière supportant le stator ; et
- un dissipateur, situé à proximité du palier arrière, adapté pour recevoir la plaque de masse inférieure de l'ensemble électronique.

Selon un mode de réalisation non limitatif, la machine électrique tournante est un alterno-démarreur.

### BREVE DESCRIPTION DES FIGURES

L'invention et ses différentes applications seront mieux comprises à la lecture de la description qui suit et à l'examen des figures qui l'accompagnent.
- la figure 1 représente une vue éclatée en perspective d'un mode de réalisation non limitatif d'un ensemble électronique pour machine électrique tournante pour véhicule automobile, ledit ensemble électronique comprenant une pièce-boîtier surmoulée en matériau plastique selon l'invention ;
- la figure 2 représente une vue de dessus de la pièce-boîtier surmoulée de l'ensemble électronique de puissance de la figure 1 ;
- la figure 3 représente une vue en coupe axiale de la pièce-boîtier surmoulée de la figure 2 ;
- la figure 4 représente une vue en coupe radiale de la pièce-boîtier surmoulée de la figure 3 ;
- la figure 5 représente une vue en perspective d'un mode de réalisation non limitatif d'un module de puissance de l'ensemble électronique de la figure 1 ;
- la figure 6 représente une vue en perspective d'un support conducteur du module de puissance de la figure 5 ;
- la figure 7 représente une vue éclatée en perspective de la pièce-boîtier surmoulée en matériau plastique et d'une plaque de masse inférieure de l'ensemble électronique de puissance de la figure 1 ;
- la figure 8 représente une vue éclatée en perspective de l'assemblage de l'ensemble électronique de la figure 1 sur un dissipateur de la machine électrique tournante ;
- la figure 9 représente une vue en perspective de l'ensemble électronique de la figure 8 assemblé sur le dissipateur de la machine électrique tournante ;
- la figure 10 représente une vue en perspective de l'ensemble électronique de puissance de la figure 8 assemblé sur le dissipateur de la machine électrique tournante comprenant un module de contrôle.

### DESCRIPTION DE MODES DE REALISATION DE L'INVENTION

Les éléments identiques, par structure ou par fonction, apparaissant sur différentes figures conservent, sauf précision contraire, les mêmes références.

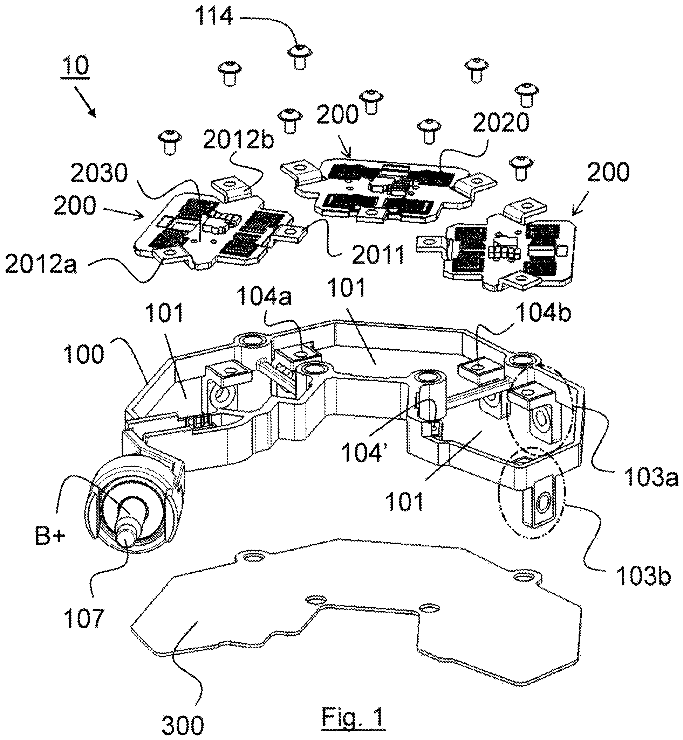

L'ensemble électronique 10 pour machine électrique tournante est décrit en référence aux figures 1 à 10.

La machine électrique tournante est dans un exemple non limitatif un alterno-démarreur. La machine électrique tournante est dans ce type d'application utilisée pour la génération électrique et le démarrage du moteur thermique (avec la fonctionnalité dite « Stop & Go » ou « Stop/Start » en anglais).

Tel qu'illustré à la figure 1, selon un mode de réalisation non limitatif, l'ensemble électronique 10 comporte :
- une pièce-boîtier surmoulée 100 en matériau plastique (appelée en anglais « housing ») ;
- une pluralité de modules de puissance 200 ;
- une plaque de masse inférieure 300 (appelée en anglais « backplate ») adaptée pour recevoir ladite pièce-boîtier surmoulée 100 et pour être montée sur un dissipateur 11 de la machine électrique tournante et destinée à être reliée à la borne de potentiel négatif de la batterie du véhicule.

Les différents éléments de l'ensemble électronique 10 sont décrits plus en détail ci-après.

### Pièce-boîtier surmoulée

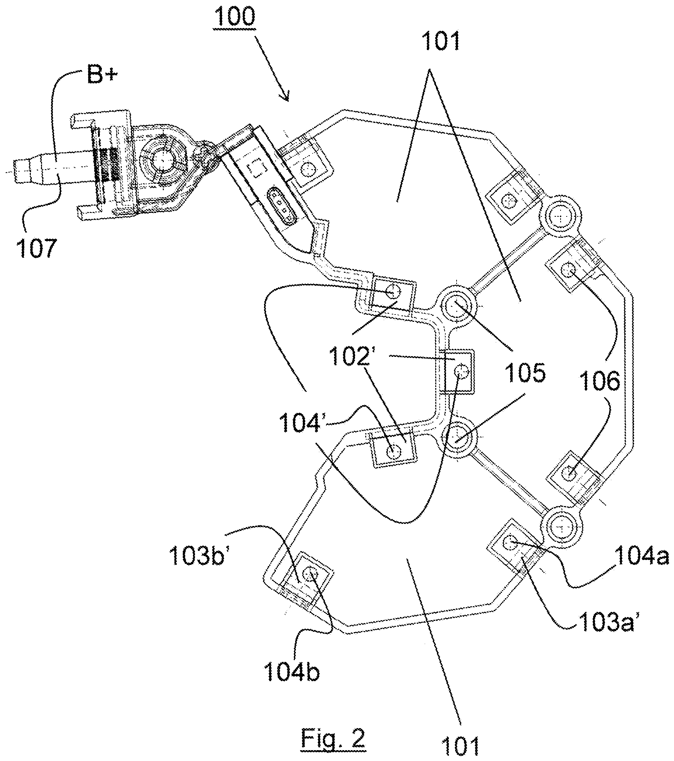

La pièce-boîtier surmoulée 100 est illustrée sur la figure 2 à 4.

Elle a notamment pour fonction la protection mécanique des modules de puissance 200 et la tenue mécanique de l'ensemble des modules de puissance sur la machine électrique tournante. De plus, elle permet d'accueillir l'interconnexion avec le module de contrôle.

La pièce-boîtier surmoulée 100 est en matériau plastique. Dans un mode de réalisation non limitatif, le matériau plastique est le PPS (Sulfure de Polyphénylène), le PBT (Polytéréphtalate de butylène) ou le PPA (Polyphtalamides).

Ces types de plastiques sont des plastiques peu coûteux dont les tenues en température sont de l'ordre de 120°C à 250°C. Il n'est en effet pas nécessaire d'utiliser un plastique haut de gamme qui supporte des températures plus hautes car il n'y a pas de soudures électriques ni de soudures laser des modules de puissance 200 effectuées au niveau de la pièce-boîtier surmoulée.

La pièce-boîtier surmoulée 100 comporte :
- une pluralité de logements 101 ;
- une pluralité de traces conductrices de puissance comportant des traces de phases 103a, 103b et une trace B+ 102 (connectée à la borne de puissance 107) ; et
- des orifices de montage 104', 104a, 104b.

Tel qu'illustré sur la figure 2, les logements 101 sont adaptés pour recevoir chacun un module de puissance 200. Dans l'exemple illustré non limitatif, il y a trois logements 101 permettant de monter trois modules de puissance 200 dans la pièce-boîtier surmoulée 100.

La pièce conductrice de puissance 102 appelée également trace de puissance, ou encore bus de puissance, permet le passage de courant dans les composants des modules de puissance 200. Elle est surmoulée dans ladite pièce-boîtier surmoulée 100 tel qu'illustré sur les figures en coupe 3 et 4. Elle comporte une pluralité de languettes de connexion de puissance externes 102' surmoulées, une languette de connexion de puissance 102' étant associée à un module de puissance 200. Ainsi, une languette de connexion de puissance 102' débouche dans chaque logement 101 et est adaptée pour coopérer avec un connecteur de puissance (décrit plus loin) d'un module de puissance 200. Les languettes 102' sont positionnées parallèlement par rapport au plan (horizontal) de la pièce-boîtier surmoulée 100 ; cela permet de réduire l'encombrement vertical de l'ensemble électronique 10.

Les traces de phases 103a, 103b, tel qu'illustré sur la figure 1, sont surmoulées dans ladite pièce-boîtier surmoulée 100. Deux traces de phase 103a, 103b sont associées à un module de puissance 200. Elles permettent de connecter chaque module de puissance 200 aux phases du stator. Dans la forme de réalisation particulière décrite ici, deux traces de phases 103a, 103b sont disposées dans chaque logement 101 en équerre par rapport au plan de ladite pièce-boîtier surmoulée 100. Le fait de surmouler les traces de phases 103a, 103b apporte de la modularité quant à la position des sorties de phase du stator. On peut choisir facilement de surmouler les traces à tel ou tel endroit de la pièce-boîtier surmoulée en fonction des souhaits des constructeurs de machine électrique par exemple et du nombre de phases de la machine.

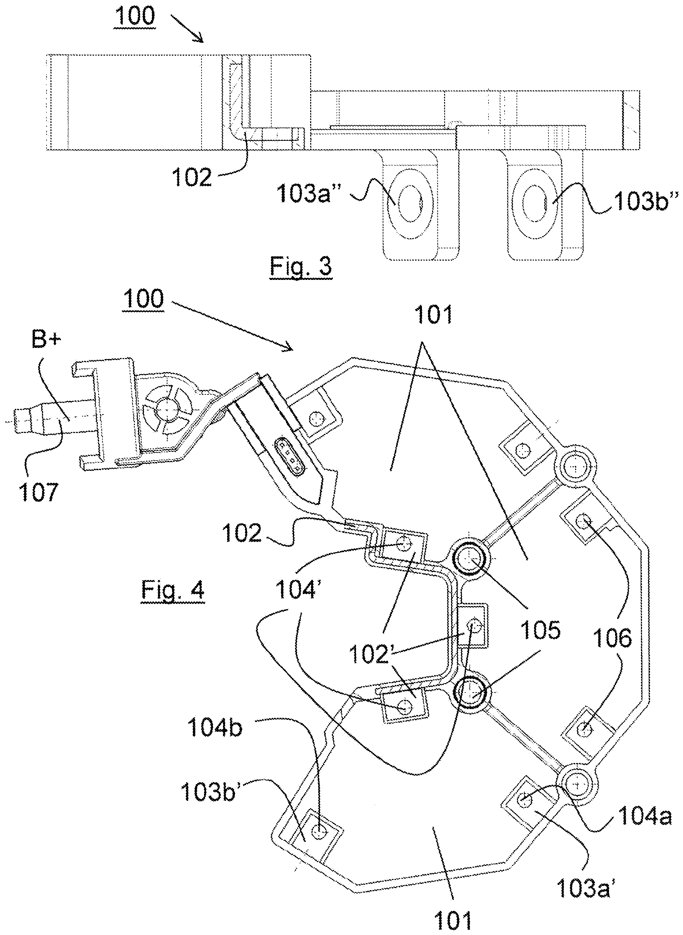

Les traces de phases 103a, 103b comportent respectivement chacune :
- une première languette de connexion de phase 103a', 103b' surmoulée adaptée pour connecter un module de puissance 200. Deux premières languettes de connexion de phase 103a', 103b' sont adaptées pour coopérer avec des connecteurs de phase (décrits plus loin) d'un module de puissance 200. Tel qu'illustré sur la figure 2 ou 4, les premières languettes 103a', 103b' sont positionnées parallèlement au plan de la pièce-boîtier surmoulée 100 ; cela permet de réduire l'encombrement vertical de l'ensemble électronique 10.
- une deuxième languette de connexion de phase 103a", 103b" surmoulée adaptée pour connecter une phase du stator. Deux premières languettes de connexion de phase 103a", 103b" sont adaptées pour coopérer avec des phases du stator. Tel qu'illustré sur la figure 3, les premières languettes 103a", 103b" sont positionnées verticalement par rapport au plan (horizontal) de la pièce-boîtier surmoulée 100 ; cela permet d'accéder facilement auxdites languettes pour la connexion avec les phases du stator.

Les orifices de montage 104', 104a et 104b illustrés sur les figures 2 et 4, sont adaptés pour recevoir des moyens de montage 114 pour monter chaque module de puissance 200 sur ladite pièce-boîtier surmoulée 100.

Toujours dans cette forme de réalisation particulière d'une machine comportant six phases, chaque logement 101 comporte trois orifices de montage 104', 104a et 104b, un orifice 104' étant intégré dans la languette de puissance 102' et un orifice 104a et 104b étant intégré respectivement dans chaque languette de phase 103a', 103b'.

Tel qu'illustré sur la figure 4, la pièce-boîtier surmoulée 100 comporte en outre :
- des premiers orifices de montage 105 adaptés pour monter la pièce-boîtier surmoulée 100 sur un dissipateur 11 du palier arrière de la machine électrique tournante. Ces deux orifices 105 sont placés sur la circonférence intérieure de ladite pièce-boîtier surmoulée 100 ; et
- des deuxièmes orifices de montage 106 adaptés pour monter la pièce-boîtier surmoulée 100 sur le dissipateur 11 du palier arrière de la machine électrique tournante. Ces deux orifices 106 sont placés sur la circonférence extérieure de ladite pièce-boîtier surmoulée 100.

On notera que la circonférence intérieure de la pièce-boîtier surmoulée 100 se trouve à la périphérie d'un emplacement 108 destiné à recevoir l'arbre du rotor.

Les premiers et deuxièmes orifices de montage sont adaptés pour recevoir des moyens de montage tels que dans un exemple non limitatif des vis de fixation (non représentées).

Ainsi, ces moyens de montage 105-106 de la pièce-boîtier surmoulée permettent de monter l'ensemble des modules de puissance 200 sur le dissipateur de la machine électrique tournante. Il n'existe plus de moyens de montage associés à chaque module de puissance. On réduit ainsi le nombre de moyens de montage ce qui permet d'optimiser le volume occupé par l'ensemble électronique 10. Ces moyens de montage 105-106-vis permettent de monter et démonter facilement la pièce-boîtier surmoulée 10 de la machine électrique tournante sans risque de détérioration.

On notera que la pièce-boîtier surmoulée 100 comporte en outre un bus de signal (non illustré) qui se connecte de manière classique, dans un exemple non limitatif par câblage par fil (« wire bonding »), aux composants de signaux des modules de puissance. Les modules de puissance sont décrits ci-dessous.

### Module de puissance

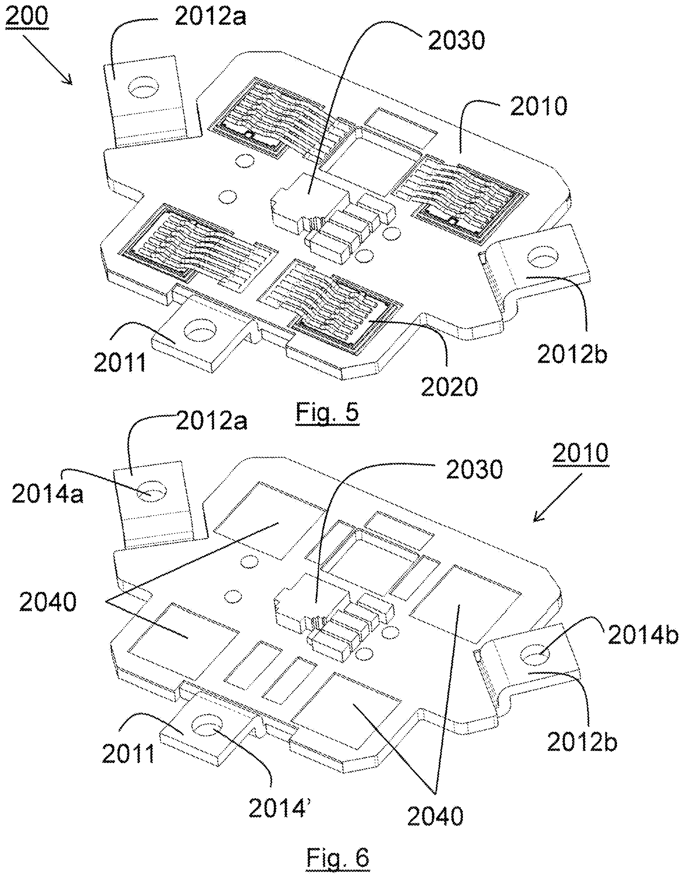

Un module de puissance 200 est illustré sur les figures 5 et 6 dans des modes de réalisation non limitatifs.

Tel qu'illustré sur la figure 5, un module de puissance 200 comporte :
- un substrat conducteur 2010 intégrant trois traces de puissance, à savoir, une trace B+, une trace de phase et une trace de masse ;
- une pluralité d'interrupteurs électroniques de puissance 2020 montés sur des traces de puissance apparentes ; et
- un circuit de commande intégrant des composants de signal 2030, intégré au substrat.

Les interrupteurs électroniques de puissance 2020 et les composants de signal 2030 sont montés sur le substrat conducteur 2010.

Les interrupteurs électroniques sont dans un exemple non limitatif des transistors MOSFET, les interrupteurs d'un module étant destinés à réaliser au moins un bras de pont redresseur/onduleur pour une phase de la machine électrique tournante. Dans les deux exemples illustrés, le module de puissance 200 comporte deux MOSFET pour un bras de pont. On peut donc facilement adapter l'ensemble électronique 10 pour une machine triphasée ou une machine hexaphasée. Dans le cas d'une machine triphasée, il suffit de ne connecter qu'un connecteur de phase (décrit ci-après) à une phase du stator via trace de phase 103a ou 103b de la pièce-boîtier surmoulée 100, tandis que dans le cas d'une machine hexaphasée il suffit de connecter les deux connecteurs de phase (décrits ci-après) à deux phases du stator via deux traces de phase 103a et 103b de la pièce-boîtier surmoulée 100.

Tel qu'illustré sur la figure 6, le support conducteur 2010 comprend :
- un connecteur de puissance 2011 adapté pour être connecté à la pièce conductrice de puissance 102 de ladite pièce-boîtier surmoulée 100, via une de ses languettes de puissance 102' ;
- au moins deux connecteurs de phase 2012a et 2012b adaptés pour être connectés respectivement aux traces de phases 103a et 103b de ladite pièce-boîtier surmoulée 100 via les deux premières languettes correspondantes 103a' et 103b'.

Les connecteurs de puissance 2011 et de phase 2012a, 2012b intègrent des orifices de montage respectif 2014', 2014a, 2014b correspondant aux orifices de montage 104', 104a, 104b de la pièce-boîtier surmoulée 100, à savoir, les orifices 2014', 2014a, 2014b sont adaptés pour être positionnés respectivement en vis-à-vis des orifices de montage 104', 104a, 104b. Dans l'exemple illustré, un module de puissance 100 comporte 3 orifices de montage 2014', 2014a, 2014b. Ils permettent de recevoir les moyens de montage 114, qui sont dans un exemple non limitatif des vis de fixation.

On notera que les vis de fixation 114 permettent non seulement d'effectuer la tenue mécanique des modules de puissance dans la pièce-boîtier surmoulée 100 mais également d'effectuer ensemble avec les connecteurs 2011 et 2012a et 2012b respectivement une connexion électrique entre les modules de puissance 200 et la pièce conductrice de puissance 102, et une connexion électrique entre les modules de puissance 200 et les traces de phases 103a, 103b.

Les connecteurs de puissance 2011 et de phase 2012a et 2012b sont positionnés parallèlement au plan du support conducteur 2010 ce qui permet de réduire l'encombrement vertical de l'ensemble électronique 10.

Un module de puissance 200 peut être ainsi monté et démonté facilement de la pièce-boîtier surmoulée 100 via les vis de fixation 114 qui s'insèrent dans les orifices de montage 2014', 2014a, 2014b et 104', 104a, 104b. Il est ainsi possible de démonter un ou plusieurs modules de puissance défectueux sans détériorer le reste de l'ensemble électronique 10 ou de la machine électrique tournante.

On notera par ailleurs, que l'on a remplacé les soudures de phase présentes dans l'état de la technique antérieure par des moyens mécaniques qui remplissent une fonction de connexion électrique. En supprimant ces soudures de phase, on réduit l'encombrement vertical de l'ensemble électronique puisqu'il n'est plus nécessaire d'avoir des accès spécifiques auxdites phases pour réaliser une soudure.

Dans un mode de réalisation non limitatif illustré sur les figures 5 et 6, le support de puissance conducteur 2010 du module de puissance 200 est constitué de trois traces conductrices de puissance séparées par une couche isolante (époxy) et accueillant un circuit imprimée PCB (« Printed Circuit Board ») pour les composants 2030 (en anglais « driver ») de la commande des interrupteurs électroniques 2020. Les interrupteurs électroniques de puissance 2020 étant soudés directement sur les parties apparentes des traces de puissance 2040.

Ainsi, avec ce mode de réalisation, on remplace la pluralité de boîtiers (présents dans l'état de la technique antérieure) des modules de puissance en matière plastique qui permet de tenir de très hautes températures, par un boîtier unique, à savoir la pièce-boîtier surmoulée 100, en matière plastique qui permet de tenir des températures moins élevées, boîtier unique dans lequel sont montés les modules de puissance sans soudures électriques et laser, le montage sur le dissipateur de la machine électrique étant effectué via des moyens mécaniques de montage communs à tous les modules.

### Plaque de masse inférieure

La plaque de masse inférieure 300 supporte la pièce-boîtier surmoulée 100. La plaque est dans un mode de réalisation non limitatif en aluminium et comporte une partie isolante électriquement (anodization par exemple) afin d'assurer un bon isolement avec les traces conductrices de puissance (leadframe) de potentiel B+ et de phases et une partie conductrice pour réaliser la connexion de masse des modules de puissance via une connexion par fils brasés (« wire bonding » en anglais) avec les interrupteurs électroniques de puissance (MOSFET).

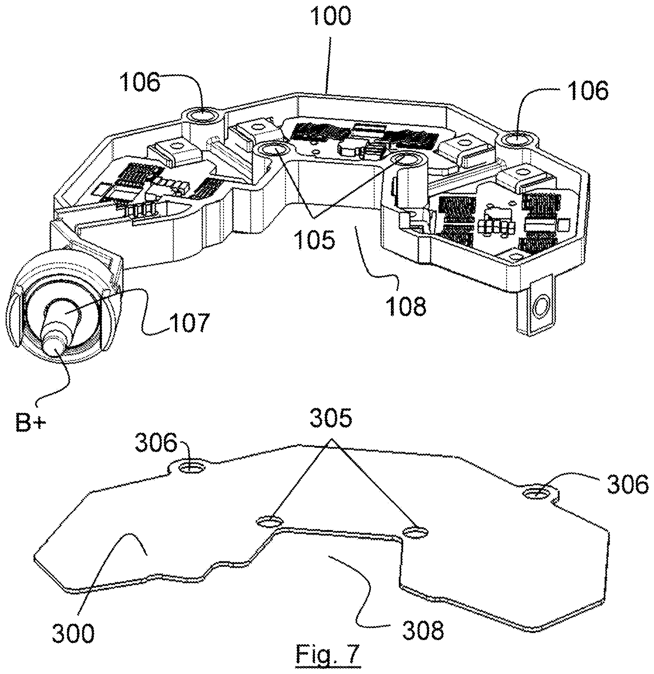

Telle qu'illustré sur la figure 7, la plaque 300 comporte :
- des troisièmes orifices de montage 305 adaptés pour être couplés aux premiers orifices de montage correspondant 105 de la pièce-boîtier surmoulée 100. Dans un exemple non limitatif, elle comporte deux orifices 305 placés sur la circonférence intérieure de ladite plaque 300 ;
- des quatrièmes orifices de montage 306 adaptés pour être couplés aux deuxièmes orifices de montage correspondant 106 de la pièce-boîtier surmoulée 100. Dans un exemple non limitatif, elle comporte deux orifices 306 placés sur la circonférence extérieure de ladite plaque 300.

On notera que la circonférence intérieure de la plaque 300 se trouve à la périphérie d'un emplacement 308 destiné à recevoir l'arbre du rotor.

Les troisièmes et quatrièmes orifices de montage 305 et 306 ensemble avec des vis de montage (non illustrées) permettent de monter la pièce-boîtier surmoulée 100 sur la plaque de masse inférieure 300 et sur le dissipateur 11 du palier arrière de la machine électrique tournante. Ainsi, l'ensemble des orifices de montage 105-106 et 305-306 sont adaptés pour monter l'ensemble électronique 10 sur le dissipateur 11.

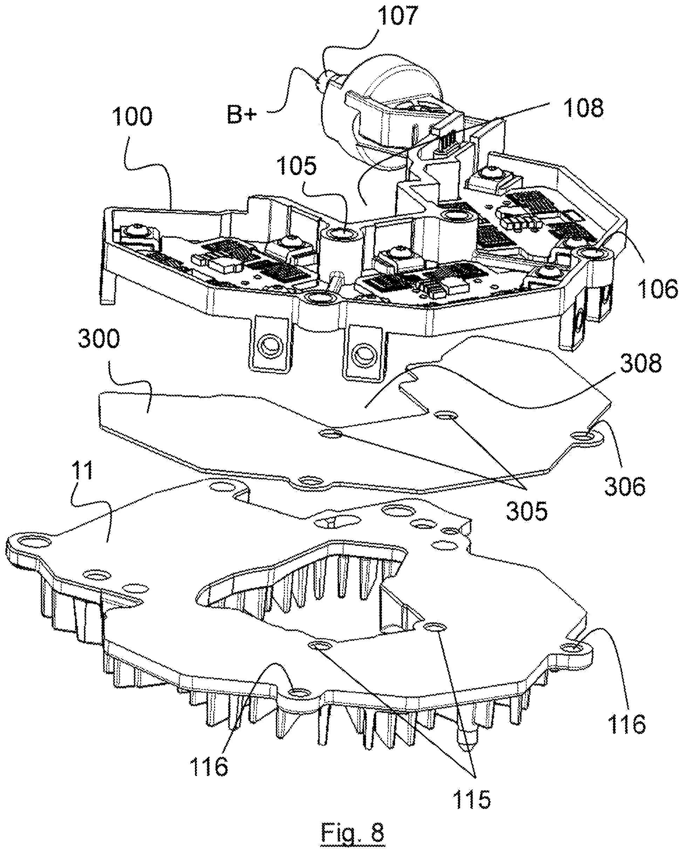

Tel qu'illustré sur la figure 8, La plaque 300 se monte directement sur le dissipateur 11. Elle est ainsi reliée électriquement au potentiel général de masse du véhicule.

On rappelle que dans le mode de réalisation non limitatif dans lequel la machine électrique tournante est une machine de type alterno-démarreur fonctionnant sous une tension continue adaptée à un véhicule avec un réseau électrique 48 Volts (ou tout autre tension), par exemple, des potentiels de tension B+ et B- sont présents dans la machine et correspondent respectivement au +48 V et au 0 V du 48 Volts. On notera ici que le B- (0 V) et le potentiel général de masse du véhicule sont reliés électriquement dans la machine électrique tournante.

Le potentiel B+ est relié au circuit électrique du véhicule à travers une borne électrique 107 isolée du B-. Tel qu'illustré sur les figures 2 ou 4, la pièce conductrice de puissance 102 est reliée à la borne électrique 107. La pièce conductrice 102 de la pièce-boîtier surmoulée 100 est ainsi reliée au potentiel B+. Les modules de puissance sont ainsi reliés au potentiel B+ via la pièce conductrice de puissance 102 (les connecteurs de puissance 2011 vus précédemment étant connectés à la pièce 102 via les languettes 102').

Le potentiel B- est classiquement relié à la borne électrique négative de la ou les batteries du véhicule tandis que la masse générale du véhicule est reliée au châssis de celui-ci sur lequel est monté le palier arrière 11 de la machine électrique. La plaque de masse inférieure 300 est ainsi reliée directement à la masse du véhicule puisque montée sur le dissipateur 11 du palier arrière de ladite machine. La plaque 300 permet ainsi de mettre à la masse le support conducteur 2010 des modules de puissance 200 lorsque ces derniers sont montés dans les logements 101 de la pièce-boîtier surmoulée 100, chaque support 2010 étant alors en contact avec la plaque 300.

L'assemblage des différents éléments de l'ensemble électronique 10 s'effectue de la manière suivante :
- chaque module de puissance 200 est monté dans le logement 101 prévu à cet effet de la pièce-boîtier surmoulée 100 par les trois vis de fixation 114 insérées dans les orifices 2014', 2014a, 2014b et 104', 104a, 104b ;
- la pièce-boîtier surmoulée 100 est montée sur la plaque de masse inférieure 300 ;
- l'ensemble pièce-boîtier surmoulée 100-plaque de masse 300 est monté sur le dissipateur 11 du palier arrière de la machine électrique tournante au moyen de l'ensemble vis de fixation-orifices de montage 305-306 et 105-106.

Bien entendu, la séquence des étapes décrites ci-dessus peut être différente. On peut ainsi monter les modules 200 dans la pièce-boîtier surmoulée 100 après avoir monté l'ensemble pièce-boîtier surmoulée 100-plaque de masse 300 sur le dissipateur.

La figure 8 illustre en éclaté l'assemblage de l'ensemble électronique 10 sur le dissipateur 11 du palier arrière de la machine électrique tournante. Le dissipateur 11 comporte des premiers orifices de montage 115 qui se retrouvent en vis-à-vis des troisièmes orifices 305 et premiers orifices 105 respectivement de la plaque de masse inférieure 300 et de la pièce-boîtier surmoulée 100, et des deuxièmes orifices de montage 116 qui se retrouvent en vis-à-vis des quatrièmes orifices 306 et 1deuxièmes orifices 06 respectivement de la plaque de masse inférieure 300 et de la pièce-boîtier surmoulée 100.

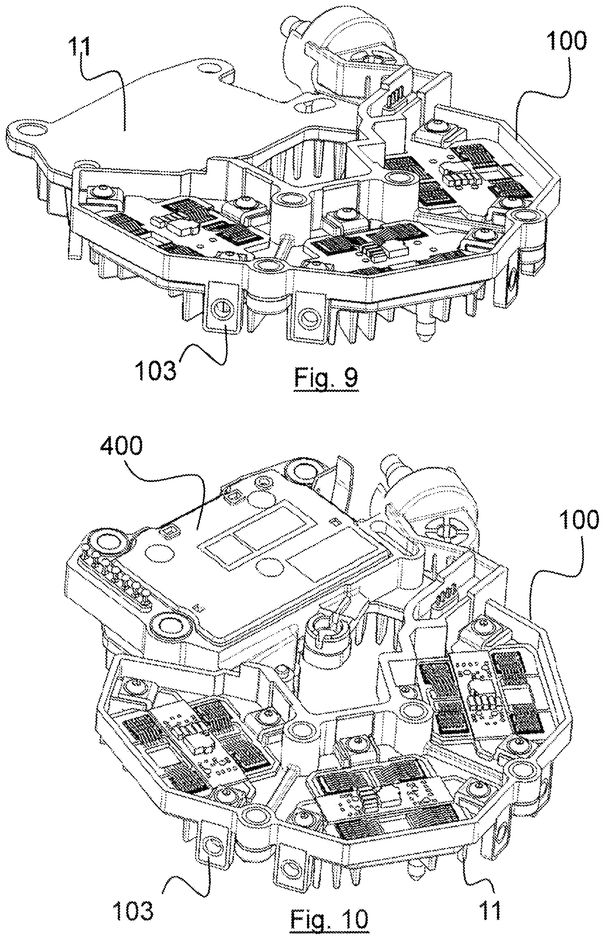

La figure 9 et la figure 10 montrent l'ensemble électronique 10 assemblé sur le dissipateur 11 du palier arrière de la machine électrique tournante.

La figure 10 illustre en outre dans un mode de réalisation non limitatif un élément supplémentaire 400 qui comprend un module de contrôle. Le module de contrôle comporte des composants pour contrôler la machine électrique tournante et notamment le réglage de la machine en contrôlant les modules de puissance via le bus de signal. Les composants de contrôle étant connus de l'homme du métier, ils ne sont pas décrits en détail dans la suite de la description. Bien entendu, d'autres modes de réalisation peuvent être réalisés dans lesquels le module de contrôle est par exemple disposé au dessus de la pièce-boîtier surmoulée sur un plan parallèle à ladite pièce-boîtier surmoulée.

Ainsi, l'ensemble électronique 10 décrit permet de faire fonctionner l'alterno-démarreur. Ce dernier comporte :
- un rotor ;
- un stator couplé audit rotor et comportant une pluralité de phases ;
- un ensemble électronique 10 selon l'une quelconque des caractéristiques précédentes, la pièce-boîtier surmoulée 100 en matériau plastique dudit ensemble électronique 10 étant adaptée pour être connectée aux phases dudit stator ;
- un palier arrière supportant ledit stator ; et
- un dissipateur sur lequel repose l'ensemble électronique 10.

Bien entendu la description de l'invention n'est pas limitée à l'application, aux modes de réalisation et aux exemples décrits ci-dessus.

Ainsi, la présente invention s'applique à tout type de machines électriques tournantes polyphasées réversibles, tels que des alterno-démarreurs, entraînées par exemple par courroie ou intégrée, et notamment pour des applications hybrides.

Ainsi, dans un mode de réalisation non limitatif, l'ensemble électronique 10 peut comporter autant de modules de puissance que nécessaire (deux phases par module au maximum) afin de réaliser une machine à trois, cinq, six ou sept phases.

Ainsi, dans un autre mode de réalisation non limitatif, le module de puissance 200 peut comporter une céramique comprenant les composants de commande (driver) des interrupteurs électroniques et les composants de signal. Les interrupteurs électroniques sont reportés sur le support conducteur par brasure et liaison filaire (« wire bonding »). Dans ce cas, le module de puissance comporte en outre un contour en matériau plastique qui permet la tenue mécanique de l'ensemble des éléments du module de puissance entre eux. Dans des modes de réalisation non limitatifs, le matériau plastique du contour est du PEEK (polyétheréthercétone) ou du PPA (polyphtalamide). Ces plastiques sont des plastiques haut de gamme très performants qui peuvent être utilisées à de fortes températures, par exemple aux alentours de 350°C, ce qui est intéressant lors de la brasure des interrupteurs électroniques sur le support conducteur.

Ainsi, avec ce mode de réalisation, on utilise un boîtier unique, à savoir la pièce-boîtier surmoulée 100, dans lequel sont montés les modules de puissance sans soudures électriques et laser, le montage sur le dissipateur de la machine électrique étant effectué via des moyens mécaniques de montage communs à tous les modules.

Ainsi, dans un autre mode de réalisation non limitatif, on peut utiliser une technologie dite « copper in lay » pour les modules de puissance 200.

Ainsi, l'invention décrite présente notamment les avantages suivants :
elle permet de démonter facilement :
   - un module de puissance qui ne fonctionne pas sans risquer de détériorer l'ensemble électronique ou la machine électrique tournante ;
   - la pièce-boîtier surmoulée et la plaque de masse sans risquer de détériorer la machine électrique tournante ;
   - elle évite de mettre au rebut la machine électrique complète puisqu'on s'affranchit des soudures électriques et laser lors de l'intégration de la pièce-boîtier surmoulée comprenant les modules de puissance à la machine électrique ;
   - elle réduit le volume occupé par l'ensemble électronique sur la machine électrique :
      - en remplaçant les moyens de montage de chaque module de puissance qui existaient dans l'état de la technique antérieure par des moyens de montage communs à tous les modules de puissance et présents sur la pièce-boîtier surmoulée ;
      - en supprimant une pièce de puissance de l'état de la technique antérieure, à savoir l'inter-connecteur de puissance ;
      - en remplaçant les boîtiers électroniques plastiques de chaque module de puissance par un unique boîtier électronique plastique, à savoir la pièce-boîtier surmoulée ;
   - elle réduit le coût total de l'ensemble électronique :
      - en utilisant un plastique peu coûteux pour la pièce-boîtier surmoulée ;
      - en supprimant les soudures électriques et laser propres à chaque module de puissance qui existaient dans l'état de la technique antérieure ;
      - en utilisant une carte PCB pour les modules de puissance ;
   - elle permet de choisir la position des sorties de phases du stator grâce au surmoulage des traces de phase dans la pièce-boîtier surmoulée. On s'affranchit ainsi des contraintes de position donnée des sorties de phase ;
   - elle permet d'adapter facilement l'ensemble électronique pour une machine triphasée, hexaphasée ou autre.

## Revendications

1. Ensemble électronique (10) pour machine électrique tournante pour véhicule automobile selon lequel ledit ensemble électronique (10) comporte :
- une pièce-boîtier surmoulée (100) en matériau plastique comprenant :
- une pluralité de logements (101) adaptés pour recevoir chacun un module de puissance (200) ;
- une pièce conductrice de puissance (102) surmoulée dans ladite pièce-boîtier surmoulée (100)
- des orifices de montage (104', 104a, 104b) adaptés pour recevoir des moyens de montage (114) pour monter chaque module de puissance (200) sur ladite pièce-boîtier surmoulée (100) ;
- **caractérisé en ce que**: - la pièce-boîtier surmoulé (100) comporte une pluralité de traces de phases et masse (103a,103b,102); - l'ensemble électronique (10) comporte en outre:
- une pluralité de modules de puissance (200) comprenant :
- un support conducteur (2010) sur laquelle sont montés :
- une pluralité d'interrupteurs électroniques de puissance (2020) ;
- des composants de signal (2030) ;
ledit support conducteur (2010) comprenant :
- un connecteur de puissance (2011) adapté pour être connecté à la pièce conductrice de puissance (102) de ladite pièce-boîtier surmoulée (100) ;
- au moins deux connecteurs de phase (2012a, 2012b) adaptés pour être connectés aux traces de phases (103a, 103b) de ladite pièce-boîtier surmoulée (100) ;
- une plaque de masse inférieure (300) adaptée pour recevoir ladite pièce-boîtier surmoulée (100) et pour être montée sur un dissipateur (11) de la machine électrique tournante.

2. Ensemble électronique (10) selon la revendication 1, selon lequel le matériau plastique de la pièce-boîtier surmoulée (100) est du PPS ou PBT.

3. Ensemble électronique (10) selon la revendication 1 ou la revendication 2, selon lequel la pièce conductrice de puissance (102) de ladite pièce-boîtier surmoulée (100) comporte une pluralité de languettes de connexion de puissance (102') disposées parallèlement au plan de la pièce-boîtier surmoulée (100), une languette de connexion de puissance (102') étant adaptée pour coopérer avec un module de puissance (200).

4. Ensemble électronique (10) selon l'une quelconque des revendications précédentes 1 à 3, selon lequel les traces de phase (103a, 103b) de ladite pièce-boîtier surmoulée (100) comportent chacune une première languette de connexion de phase (103a', 103b') adaptée pour connecter un module de puissance (200), une première languette de connexion de phase (103a', 103b') étant positionnée parallèlement par rapport au plan de la pièce-boîtier surmoulée (100).

5. Ensemble électronique (10) selon l'une quelconque des revendications précédentes 1 à 4, selon lequel les traces de phase (103a, 103b) de ladite pièce-boîtier surmoulée (100) comportent chacune une deuxième languette de connexion de phase (103a", 103b") adaptée pour connecter une phase du stator, une deuxième languette (103a", 103b") étant positionnée verticalement par rapport au plan de la pièce-boîtier surmoulée (100).

6. Ensemble électronique (10) selon l'une quelconque des revendications précédentes 1 à 5, selon lequel la pièce-boîtier surmoulée (100) comporte des premiers et deuxièmes orifices de montage (105-106) et la plaque de masse inférieure (300) comporte des troisièmes et quatrièmes orifices de montage (305-306), lesdits orifices de montage (105-106 ; 305-306) étant adaptés pour monter ledit ensemble électronique (10) sur un dissipateur (11) de la machine électrique tournante.

7. Ensemble électronique (10) selon l'une quelconque des revendications précédentes 1 à 6, selon lequel le support conducteur (2010) d'un module de puissance (200) est une carte à circuit imprimée PCB.

8. Ensemble électronique (10) selon l'une quelconque des revendications précédentes 1 à 7, selon lequel les connecteurs de puissance (2011) et de phase (2012a, 2012b) d'un module de puissance (200) comprennent des orifices de montage respectifs (2014', 2014a, 2014b) adaptés pour être positionnés en vis-à-vis desdits orifices de montage (104', 104a, 104b) de la pièce-boîtier surmoulée (100) et pour recevoir lesdits moyens de montage (114).

9. Ensemble électronique (10) selon l'une quelconque des revendications précédentes 1 à 8, selon lequel les connecteurs de puissance (2011) et de phase (2012a, 2012b) d'un module de puissance sont positionnés parallèlement au plan dudit support conducteur (2010).

10. Machine électrique tournante comportant :
- un rotor ;
- un stator couplé audit rotor et comportant une pluralité de phases ;
- un ensemble électronique (10) selon l'une quelconque des revendications précédentes, ladite pièce-boîtier surmoulée (100) en matériau plastique dudit ensemble électronique (10) étant adaptée pour être connectée aux phases dudit stator ;
- un palier arrière supportant ledit stator ; et
- un dissipateur (11) sur lequel est monté ledit ensemble électronique (10).

11. Machine électrique tournante, selon la revendication précédente 10, selon laquelle ladite machine électrique tournante est un alterno-démarreur.

## Patentansprüche

1. Elektronische Baugruppe (10) für eine elektrische Drehmaschine eines Kraftfahrzeugs, wobei die elektronische Baugruppe (10) umfasst:
- ein aufgeformtes Gehäuseteil (100) aus Kunststoff, umfassend:
- eine Vielzahl von Aufnahmen (101), die geeignet sind, jeweils ein Leistungsmodul (200) aufzunehmen;
- ein leitendes Leistungsteil (102), das in dem aufgeformten Gehäuseteil (100) aufgeformt ist,
- Montageöffnungen (104', 104a, 104b), die geeignet sind, Montagemittel (114) aufzunehmen, um jedes Leistungsmodul (200) auf dem aufgeformten Gehäuseteil (100) zu montieren;
**dadurch gekennzeichnet, dass**:
- das aufgeformte Gehäuseteil (100) eine Vielzahl von Phasen- und Massenspuren (103a, 103b, 102) umfasst;
- die elektronische Baugruppe (10) ferner umfasst:
- eine Vielzahl von Leistungsmodulen (200), umfassend:
- einen leitenden Träger (2010), auf dem montiert sind:
- eine Vielzahl von elektronischen Leistungsschaltern (2020);
- Signalkomponenten (2030);
wobei der leitende Träger (2010) umfasst:
- einen Leistungsstecker (2011), der geeignet ist, an das leitende Leistungsteil (102) des aufgeformten Gehäuseteils (100) angeschlossen zu werden;
- mindestens zwei Phasenstecker (2012a, 2012b), die geeignet sind, an die Phasenspuren (103a, 103b) des aufgeformten Gehäuseteils (100) angeschlossen zu werden;
- eine untere Massenplatte (300), die geeignet ist, das aufgeformte Gehäuseteil (100) aufzunehmen und auf einem Wärmeableiter (11) der elektrischen Drehmaschine montiert zu werden.

2. Elektronische Baugruppe (10) nach Anspruch 1, bei der der Kunststoff des aufgeformten Gehäuseteils (100) PPS oder PBT ist.

3. Elektronische Baugruppe (10) nach Anspruch 1 oder Anspruch 2, bei der das leitende Leistungsteil (102) des aufgeformten Gehäuseteils (100) eine Vielzahl von Leistungsverbindungslaschen (102') umfasst, die parallel zur Ebene des aufgeformten Gehäuseteils (100) angeordnet sind, wobei die Leistungsverbindungslasche (102') geeignet ist, mit einem Leistungsmodul (200) zusammenzuwirken.

4. Elektronische Baugruppe (10) nach einem der vorhergehenden Ansprüche 1 bis 3, bei der die Phasenspuren (103a, 103b) des aufgeformten Gehäuseteils (100) jeweils eine erste Phasenanschlusslasche (103a', 103b') umfassen, die geeignet ist, ein Leistungsmodul (200) anzuschließen, wobei eine erste Phasenanschlusslasche (103a', 103b') parallel zur Ebene des aufgeformten Gehäuseteils (100) angeordnet ist.

5. Elektronische Baugruppe (10) nach einem der vorhergehenden Ansprüche 1 bis 4, bei der die Phasenspuren (103a, 103b) des aufgeformten Gehäuseteils (100) jeweils eine zweite Phasenanschlusslasche (103a", 103b") umfassen, die geeignet ist, eine Phase des Stators anzuschließen, wobei eine zweite Lasche (103a", 103b") vertikal zur Ebene des aufgeformten Gehäuseteils (100) angeordnet ist.

6. Elektronische Baugruppe (10) nach einem der vorhergehenden Ansprüche 1 bis 5, bei der das aufgeformte Gehäuseteil (100) erste und zweite Montageöffnungen (105-106) umfasst, und die untere Massenplatte (300) dritte und vierte Montageöffnungen (305-306) umfasst, wobei die Montageöffnungen (105-106; 305-306) geeignet sind, die elektronische Baugruppe (10) auf einem Wärmeableiter (11) der elektrischen Drehmaschine zu montieren.

7. Elektronische Baugruppe (10) nach einem der vorhergehenden Ansprüche 1 bis 6, bei der der leitende Träger (2010) eines Leistungsmoduls (200) eine gedruckte Leiterplatte PCB ist.

8. Elektronische Baugruppe (10) nach einem der vorhergehenden Ansprüche 1 bis 7, bei der die Leistungs- (2011) und Phasenstecker (2012a, 2012b) eines Leistungsmoduls (200) jeweilige Montageöffnungen (2014', 2014a, 2014b) umfassen, die geeignet sind, gegenüber den Montageöffnungen (104', 104a, 104b) des aufgeformten Gehäuseteils (100) angeordnet zu sein und die Montagemittel (114) aufzunehmen.

9. Elektronische Baugruppe (10) nach einem der vorhergehenden Ansprüche 1 bis 8, bei der die Leistungs- (2011) und Phasenstecker (2012a, 2012b) eines Leistungsmoduls parallel zur Ebene des leitenden Trägers (2010) angeordnet sind.

10. Elektrische Drehmaschine, umfassend:
- einen Rotor;
- einen an den Rotor gekoppelten Stator, umfassend eine Vielzahl von Phasen;
- eine elektronische Baugruppe (10) nach einem der vorhergehenden Ansprüche, wobei das aufgeformte Gehäuseteil (100) aus Kunststoff der elektronischen Baugruppe (10) geeignet ist, an die Phasen des Stators angeschlossen zu werden;
- ein hinteres Lager, das den Stator trägt; und
- einen Wärmeableiter (11), auf dem die elektronische Baugruppe (10) montiert ist.

11. Elektrische Drehmaschine nach dem vorhergehenden Anspruch 10, wobei die elektrische Drehmaschine ein Startergenerator ist.

## Claims

1. Electronic assembly (10) for a rotating electrical machine for a motor vehicle, wherein said electronic assembly (10) includes:
- an overmoulded housing part (100) made of plastic and comprising:
- a plurality of recesses (101) each designed to receive a power module (200);
- a power-conducting part (102) overmoulded into said overmoulded housing part (100);
- mounting orifices (104', 104a, 104b) designed to receive mounting means (114) for mounting each power module (200) on said overmoulded housing part (100);
- **characterized in that**:
- the overmoulded housing part (100) includes a plurality of phase and ground lines (103a, 103b, 102);
- the electronic assembly (10) furthermore includes:
- a plurality of power modules (200) comprising:
- a conductive carrier (2010) on which are mounted:
- a plurality of electronic power switches (2020) ;
- signal components (2030);
said conductive carrier (2010) comprising:
- a power connector (2011) designed to be connected to the power-conducting part (102) of said overmoulded housing part (100) ;
- at least two phase connectors (2012a, 2012b) designed to be connected to the phase lines (103a, 103b) of said overmoulded housing part (100);
- a backplate (300) designed to receive said overmoulded housing part (100) and to be mounted on a dissipator (11) of the rotating electrical machine.

2. Electronic assembly (10) according to Claim 1, wherein the plastic of the overmoulded housing part (100) is PPS or PBT.

3. Electronic assembly (10) according to Claim 1 or Claim 2, wherein the power-conducting part (102) of said overmoulded housing part (100) includes a plurality of power connection tabs (102') arranged in parallel with the plane of the overmoulded housing part (100), one power connection tab (102') being designed to interact with one power module (200).

4. Electronic assembly (10) according to any one of preceding Claims 1 to 3, wherein the phase lines (103a, 103b) of said overmoulded housing part (100) each include a first phase connection tab (103a' 103b') designed to connect a power module (200), a first phase connection tab (103a', 103b') being positioned in parallel with the plane of the overmoulded housing part (100).

5. Electronic assembly (10) according to any one of preceding Claims 1 to 4, wherein the phase lines (103a, 103b) of said overmoulded housing part (100) each include a second phase connection tab (103a", 103b") designed to connect a phase of the stator, a second tab (103a", 103b") being positioned vertically with respect to the plane of the overmoulded housing part (100).

6. Electronic assembly (10) according to any one of preceding Claims 1 to 5, wherein the overmoulded housing part (100) includes first and second mounting orifices (105-106) and the backplate (300) includes third and fourth mounting orifices (305-306), said mounting orifices (105-106; 305-306) being designed to mount said electronic assembly (10) on a dissipator (11) of the rotating electrical machine.

7. Electronic assembly (10) according to any one of preceding Claims 1 to 6, wherein the conductive carrier (2010) of a power module (200) is a printed circuit board PCB.

8. Electronic assembly (10) according to any one of preceding Claims 1 to 7, wherein the power connectors (2011) and phase connectors (2012a, 2012b) of a power module (200) comprise respective mounting orifices (2014', 2014a, 2014b) designed to be positioned facing said mounting orifices (104' 104a, 104b) of the overmoulded housing part (100) and to receive said mounting means (114).

9. Electronic assembly (10) according to any one of preceding Claims 1 to 8, wherein the power connectors (2011) and phase connectors (2012a, 2012b) of a power module are positioned in parallel with the plane of said conductive carrier (2010).

10. Rotating electrical machine including:
- a rotor;
- a stator coupled to said rotor and having a plurality of phases;
- an electronic assembly (10) according to any one of the preceding claims, said overmoulded housing part (100), made of plastic, of said electronic assembly (10) being designed to be connected to the phases of said stator;
- a rear bearing carrying said stator; and
- a dissipator (11) on which said electronic assembly (10) is mounted.

11. Rotating electrical machine according to preceding Claim 10, wherein said rotating electrical machine is a starter-alternator.
